# EUROPEAN PATENT SPECIFICATION

(11) **EP 0 578 091 B1**
(45) Date of publication and mention of the grant of the patent: **02.09.1998**
(21) Application number: 93110289.1
(22) Date of filing: 28.06.1993
(51) Int. Cl.: H01L 31/0216, H01L 31/048

(54) **Resin composition for sealing and semiconductor apparatus covered with the sealing resin composition**
Harzzusammensetzung zum Dichten und eine mit Dichtharzzusammensetzung bedeckte Halbleitervorrichtung
Composition de résine pour étanchéifier et dispositif semi-conducteur recouvert de cette résine

(30) Priority: 29.06.1992 JP 194792/92; 29.06.1992 JP 194793/92; 29.06.1992 JP 194794/92; 29.06.1992 JP 194795/92; 17.11.1992 JP 307234/92
(43) Date of publication of application: 12.01.1994
(73) Proprietor: CANON KABUSHIKI KAISHA, Tokyo (JP)
(72) Inventor: Toma, Hitoshi, c/o Canon Kabushiki Kaisha, Ohta-ku, Tokyo 146 (JP); Mimura, Toshihiko, c/o Canon Kabushiki Kaisha, Ohta-ku, Tokyo 146 (JP); Takehara, Nobuyoshi, c/o Canon Kabushiki Kaisha, Ohta-ku, Tokyo 146 (JP); Tsuzuki, Koji, c/o Canon Kabushiki Kaisha, Ohta-ku, Tokyo 146 (JP)
(74) Representative: Tiedtke, Harro, Dipl.-Ing.

(56) References cited:
- EP-A- 0 002 725
- EP-A- 0 024 615
- FR-A- 2 001 918
- FR-A- 2 244 266
- US-A- 4 499 658
- US-A- 4 692 557
- PATENT ABSTRACTS OF JAPAN vol. 013, no. 255 (C-606)13 June 1989 & JP-A-01 060 677 (ARAKAWA CHEM IND CO LTD) 7 March 1989
- PATENT ABSTRACTS OF JAPAN vol. 012, no. 042 (P-663)6 February 1988 & JP-A-62 187 862 (RICOH CO LTD) 17 August 1987

## Description

### BACKGROUND OF THE INVENTION

### Field of the Invention

The present invention relates to a resin composition for sealing and a semiconductor apparatus covered with the resin composition, and more particularly to a resin composition for sealing which is capable of protecting a semiconductor or the like from various external environmental conditions such as rain, ultraviolet rays, dust and moisture and to a semiconductor apparatus covered with the resin composition.

### Related Background Art

In order to overcome the energy crisis which will occur due to a future lack of capability of supplying energy in a tendency of a rapid increase in the energy demand or the global environmental disruption occurring due to warming caused by the greenhouse effect realized by an increase in carbon dioxide, an energy supply source which is tender to the environment has been desired.

In particular, a solar cell, which is a clean and safety energy source capable of continuously supplying energy for a long time, is in the greatest expectation to meet the foregoing desire.

The solar cell comprises energy generating elements utilizing the photovoltaic effect of the semiconductor. In a general way, the following various photovoltaic elements are well-known.
(1) Crystal-type photovoltaic element
   A photovoltaic element manufactured by doping n or p-type impurities into wafer made of a p or n-type single or poly-crystal substance to form a pn-junction.
(2) Amorphous silicon type photovoltaic element
   A photovoltaic element having a pin junction formed by decomposing monosilane or silane gas with heat or high frequency electric field or light so that amorphous silicon or the like is generated and deposited, at this time introducing B₂H₆ or BF₃ gas as the p-type doping material together with the monosilane or the silane gas in the case where the p-type semiconductor is formed or similarly introducing PH₃ or the like as the n-type doping material in the case where the n-type semiconductor is formed.
(3) Compound semiconductor photovoltaic element
   A photovoltaic element having the pn-junction formed by epitaxial liquid-phase enlarging p-type GaAs on n-type GaAs or a photovoltaic element having the pn-junction formed by stacking and baking n-type CdS and p-type CdTe.

Further, a CuInSe₂ photovoltaic element, an n-type CdS/p-type CuInS₂ photovoltaic element and the like are exemplified.

The foregoing solar cells must work stably for 20 to 30 years in the outdoor environment irradiated with light. In a special case, solar cells must stably work under extreme vacuum pressure such as in the space.

In the foregoing operational environment, a stable operation is prevented due to the following various environmental factors.

The output from a solar cell is undesirably reduced due to the following major factors:
(1) Damage of the solar cell due to incidental energy of ultraviolet rays, light and other electromagnetic waves.
(2) Rust and local structural breakdown of the solar cell due to rain and moisture in the air.
(3) Deterioration in the light transmittance due to adhesion of dust and contamination to the surface.
(4) Local structural breakdown occurring due to collision of stone or dust to the surface of the solar cell.

As for the safety, there arises a problem of deterioration in the electric insulation due to rain and moisture in the air.

In order to eliminate the factors preventing the safety operation of the solar cell, such as the foregoing factors, which form a portion of all of the factors, causing the deterioration in the output, the photoelectrical conversion surface or the non-photoelectrical conversion surface of the photovoltaic element must be covered with a protection film.

Some methods of a type covering the surface with a protection film have been suggested. For example, U.S. Patent No. 3,957,537 has disclosed a technology in which a heating-type adhesive agent typified by polyvinyl butyral resin and a ternary copolymer of ethylene-methylmethacrylate-methacrylic acid is used at an intermediate position and a glass plate or the like is used to form the surface so that sealing is realized.

However, the solar cell is usually heated to a temperature of about 80°C to 100°C under the sunshine. The foregoing heating adhesive agent is excessively plasticized at the foregoing temperature and, accordingly, its adhesive force rapidly deteriorates. As a result, separation and deformation take place. Therefore, the separated or deformed portion allows rain and moisture to be invaded, causing the operation of the solar cell to deteriorate excessively. The solar cell is rapidly cooled at night because the sunshine is eliminated. For example, the solar cell is cooled to tens degrees below zero at night in an excessive case.

As described above, the temperature is sometimes changed from a high temperature region of + 80°C to 100°C to a low temperature region of tens degrees below zero between day and night. Therefore, the solar cell is placed under a severe temperature connection in which high temperature and low temperature are repeated. As a result, structural materials are expanded and contracted repeatedly, causing the separation of the heating adhesive agent to be enhanced. Therefore, the operation of the solar cell deteriorates due to rain and moisture.

From this viewpoint, there has been a desire of improving the temperature characteristics and adhesive force of the sealing material for sealing the photovoltaic element.

There has been a conventional technology in which a primer selected from various primers is used together with the adhesive agent in order to reinforce the adhesive force.

U.S. Patent No. 4,499,658 has disclosed a technology in which a silicon type primer and a cross-linking agent such as a peroxide are added to a binary copolymer of ethylene and vinyl acetate or polyvinyl butyral resin to enlarge the adhesive force and to improve the temperature characteristics.

However, it cannot be said that the foregoing sealing material has satisfactorily achieved the characteristics required to seal the photovoltaic element.

Since the sealing material basically using the heating adhesive agent is relatively soft, it can easily be damaged. Therefore, the sealing material of the foregoing type cannot satisfactorily withstand mechanical impact. Since the sealing material is basically an adhesive agent, dust can easily adhere to it, causing the light transmissivity to easily deteriorate. In order to prevent the deterioration in the light transmissivity, glass or fluorine type polymer film must be usually stacked on the surface of the sealing material. As a result, the sealing structure becomes too complicated and, accordingly, the manufacturing cost is enlarged.

What is worse, a large quantity of the sealing material must be used because of the foregoing reasons, and the material of the sealing material cannot therefore be reduced. The foregoing facts prevent the wide use of the solar cells.

In order to overcome the foregoing problems, a method of sealing the photovoltaic element using a hardening resin selected from a variety of hardening resins has been examined, in which the sealing material is caused to have sufficient strength to simplify the sealing structure and reduce the quantity of the sealing material to be used for the purpose of significantly reducing the sealing cost and improving the sealing performance.

However, the hardening resin has unsatisfactory adhesivity and, accordingly, it is easily separated. What is worse, the hardening resin encounters problems of deterioration in the adhesive force due to high temperature, change in the temperature, rain and moisture, fatigue due to light, fall of the light transmissivity due to decoloring, and unsatisfactory brittleness. Therefore, the hardening resin cannot satisfactorily seal the photovoltaic element while keeping an excellent balance.

### SUMMARY OF THE INVENTION

An object of the present invention is to provide a sealing material exhibiting excellent sealing performance while keeping satisfactory balance among a variety of characteristics thereof.

Another object of the present invention is to provide a semiconductor device such as a solar cell, the sealing structure of which can be simplified to reduce the required quantity of the sealing material and the cost of which can significantly reduced, so that the solar cell is able to be operated stably for a long time while exhibiting excellent performance.

The above objects are achieved by the resin sealing composition according to claim 1 and by a semiconductor device according to claim 5.

Other and further objects, features and advantages of the invention will be apparent more fully from the following description.

### BRIEF DESCRIPTION OF THE DRAWINGS

Fig. 1 is a schematic cross sectional view which illustrates an example of a solar cell which uses a sealing material according to the present invention;
Fig. 2 is a schematic cross sectional view which illustrates another example of an amorphous solar cell which uses a sealing material according to the present invention;
Fig. 3 is a schematic cross sectional view which illustrates another example of a solar cell which uses a sealing material according to the present invention;
Fig. 4 is a schematic cross sectional view which illustrates another example of a solar cell which uses a sealing material according to the present invention; and
Fig. 5 is a schematic cross sectional view which illustrates another example of a solar cell which uses a sealing material according to the present invention.

### DETAILED DESCRIPTION OF THE PREFERRED EMBODIMENTS

In the present invention, "soluble in a hardening resin" means a state where a relatively high molecular thermoplastic resin is equally dispersed in micron orders or equally dissolved in a molecular level in the hardening resin. From the optical viewpoint, the foregoing dissolved state is defined by an equally dispersed and somewhat turbid state in micron orders or an equally mixed and transparent state in a molecular level. The soluble state is composed of the low molecular weight hardening resin and high molecular weight thermoplastic resin. Therefore, the following advantages of the hardening resin can be obtained:
1. Excellent heat resistance
2. Hard characteristics and damage prevention caused from it.
3. Excellent water and moisture resistance
4. Excellent electric insulating characteristics

Further, following disadvantages of the hardening resin can be significantly eliminated.
1. Unsatisfactory brittle and impact resistance
2. Limitation in adhesivity with respect to some kinds of materials and undesirable easy separation
3. Easy deterioration due to light, easy occurrence of cracks and separation, and a tendency of deterioration in the light transmissivity
4. Unsatisfactory flexibility, unsatisfactory heat and temperature impact resistance, and too brittle at a low temperature

Therefore, the foregoing material can be employed as a satisfactory material for sealing the photovoltaic element which is capable of realizing the characteristics while keeping an excellent balance. Basically, a single thin film layer made of the resin composition according to the present invention is able to sufficiently seal a photovoltaic element for a long time while allowing a stable operation. Further, the sealing process can significantly be simplified and the quantity of the sealing material can be reduced to 1/10 to 1/1000. Therefore, the sealing cost can significantly be reduced.

As a result, a solar cell exhibiting excellent physical properties and capability of reducing the cost can be provided.

The hardening resin for use in the present invention is a resin which is hardened when heat or active energy is supplied. The hardening resin is exemplified by unsaturated polyester resin, phenol resin, alkyd resin, unsaturated acrylic resin, epoxy resin, polyurethane resin, melamine resin, diaryl phthalate resin, their oligomers, denatured substances, or the like. The foregoing materials may be used solely or combined with each other to obtain desired effects.

The compatibility between the hardening resin and thermoplastic resin enables the thermoplastic resin to be surrounded by the hardening resin (an assumption is made that molecules of the thermoplastic resin are expanded straightly while preventing the formation of a pill of molecules) so that an excellent resin composition for sealing a solar cell or the like is obtained.

When the hardening resin is polymer or oligomer having an acrylic group or an acrylic group which has a substituent at the position α or β and the thermoplastic resin is styrene type polymer or acrylic polymer, the resin composition for sealing a solar cell or the like has excellent characteristics. The polymer or oligomer having a polymerizable acrylic group or an acrylic group having a substituent at the position α or β is exemplified by acrylate ester oligomer, acrylate ester polymer, methacrylate ester oligomer, methacrylate ester polymer, acrylate epoxy oligomer, acrylate exposy polymer, methacrylate ester oligomer, methacrylate ester polymer, acrylate epoxy oligomer, acrylate epoxy polymer, methacrylate epoxy oligomer, methacrylate epoxy polymer, acrylate urethane oligomer, acrylate urethane polymer, methacrylate urethane polymer, acrylate melamine oligomer, acrylate melamine polymer, methacrylate melamine oligomer and methacrylate melamine polymer. Any one of the foregoing materials may be used solely or combined with each other to obtain desired effects.

The experiments conducted by the inventors resulted a knowledge to be obtained that a large molecular weight of the hardening resin causes the performance of the hardening resin for dissolving the thermoplastic resin to deteriorate gradually and the reinforcing effect realized by the thermoplastic resin deteriorates. Therefore, the preferred molecular weight of the hardening resin is 3000 or less in the number average molecular weight (obtained by a well-known gel permeation chromatogram while referring to standard polystyrene), more preferably 200 or more to 3000 or less.

The hardening means may be heat, light or an electron beam. A two-liquid mixture type substance may be hardened by mixing.

The thermoplastic resin according to the present invention may be a material selected from a group consisting of saturated polyester resin, phenol resin, acrylic resin, styrene resin, epoxy resin, urethane resin, vinyl acetate resin, vinyl chloride resin, vinyl alcohol resin, acetal resin, their denatured resin and their copolymerized resin. Any one of the foregoing materials may be used solely or they may be combined with each other to obtain desired effects.

The styrene polymer according to the present invention is a polymer, the monomer of which is at least styreme or styrene derivative or the like. The styrene copolymer is exemplified by polystyrene homopolymer, styrene butadiene copolymer, styrene-acrylnitryl copolymer and styrene-butadiene-acrylnitryl copolymer.

The acrylic polymer according to the present invention is a polymer composed of one or a plurality of monomers of acrylic acid or acrylic ester or their derivatives, or methacrylic acid or methacrylic ester or their derivatives or a copolymer, the main component of which is the foregoing monomer. The acrylic polymer is exemplified by the following polymers: acrylic ester homopolymer, acrylic ester copolymer, acrylic acid·acrylic ester copolymer, methacrylic ester homopolymer, methacrylic ester copolymer, methacrylic acid·methacrylic ester copolymer, methacrylic acid·acrylic ester copolymer, acrylic acid·methacrylic ester copolymer, methacrylic acid·acrylic acid·acrylic ester copolymer, methacrylic acid·acrylic acid·methacrylic ester copolymer and methacrylic acid·acrylic acid·methacrylic ester·acrylic ester copolymer.

The acrylic ester is a monomer exemplified by acrylic acid methyl ester, acrylic acid ethyl ester, acrylic acid propyl ester, acrylic acid butyl ester, acrylic acid octyl ester, acrylic acid dodecyl ester and acrylic acid hexadecyl ester. Their derivatives are exemplified by a monomer such as acrylic acid dihydroperfulorobutyl ester or a monomer into which a substituent is introduced into the foregoing monomer.

The methacrylic ester is a monomer such as methacrylic acid methyl ester, methacrylic acid ethyl ester, methacrylic acid propyl ester, methacrylic acid isopropyl ester, methacrylic acid butyl ester, methacrylic acid sec-butyl ester, methacrylic acid tert-butyl ester, methacrylic acid isobutyl ester, methacrylic acid aryl ester, methacrylphenyl ester and methacrylic acid benzyl ester. Their derivatives are exemplified by a monomer of a type in which a substituent is introduced into the foregoing monomer.

The styrene·acrylic polymer is one or more styrene-tye monomers of styrene or a styrene derivative or a copolymer composed of one or a plurality of monomers of acrylic acid, acrylic ester, their derivatives or methacrylic acid or methacrylic ester or their derivatives or a copolymer, the main component of which is the foregoing monomer. The styrene·acrylic polymer is exemplified by styrene acrylic ester copolymer, styrene acrylic ester copolymer, styrene acrylic acid acrylic ester copolymer, styrene methacrylic ester homopolymer, styrene methacrylic ester copolymer, styrene methacrylic acid methacrylic ester copolymer, styrene methacrylic acid acrylic ester copolymer, styrene acrylic acid methacrylic ester copolymer, styrene methacrylic acid acrylic acid acrylic ester copolymer, styrene methacrylic acid acrylic acid methacrylic ester copolymer, styrene methacrylic acid acrylic acid methacrylic ester acrylic ester copolymer.

The acrylic ester is exemplified by a monomer such as acrylic acid methyl ester, acrylic acid ethyl ester, acrylic acid propyl ester, acrylic acid butyl ester, acrylic acid octyl ester, acrylic acid dodecyl ester and acrylic acid hexadecyl ester. Their derivatives are exemplified by a monomer such as acrylic acid dihydroperfluorobutyl ester of a monomer of a type in which a substituent is introduced into the foregoing monomer.

The methacrylic ester is a monomer such as methacrylic acid methyl ester, methacrylic acid ethyl ester, methacrylic acid propyl ester, methacrylic acid isopropyl ester, methacrylic acid butyl ester, methacrylic acid sec-butyl ester, methacrylic acid tert-butyl ester, methacrylic acid isobutyl ester, methacrylic acid acryl ester, methacrylphenyl ester and methacrylic acid benzyl ester. Their derivatives are exemplified by a monomer of a type in which a substituent is introduced into the foregoing monomer.

The following fact was found from experiments that, if the molecular weight of the thermoplastic resin is too small, the quantity of solution into the hardening resin is enlarged but the length of the molecule is shortened, causing the reinforcing effect to deteriorate. According to the invention the average molecular weight of the thermoplastic resin is between 5000 and 50000.

As for the molecular form, excellent effect was obtained in the characteristics when a form is employed which includes small number of branched structures and includes a straight-chain bonding structure.

The method of dissolving the thermoplastic resin into the hardening resin is exemplified by a method in which the thermoplastic resin is dissolved into the hardening resin while stirring the thermoplastic resin and a method in which both of the foregoing resins are dissolved in an organic solvent such as toluene, alcohol, ketone or ester. The hardening means may be heat, light or electron beams. At this time, a heat polymerization initiator such as alkyl peroxy ester, dialkyl peroxide, peroxy ketal or peroxy dicarbonate or light polymerization initiator may be used simultaneously. If necessary, a so-called reactive monomer serving as a polymerization enhancing agent such as hexamethylene diacrylate or trimethylolpropane triacrylate may be added. In this case, no adverse effect takes place for the characteristics.

It is preferable that the thermoplastic resin according to the present invention is 20 to 85 wt% of the total quantity of the thermoplastic resin and the hardening resin.

One of excellent features of the resin composition according to the present invention is that no polymerization initiator does not need to be used to effect hardening or that the quantity of the same can be significatnly reduced. As a result, a variety of adverse effects caused from the polymerization initiator can be reduced significantly. Hence, the following effects can be obtained: excellent light transmissivity is realized, decoloration such as turning to yellow due to light can be prevented considerably and mechanical and optical deterioration in the physical properties such as the deterioration in the strength and devirtrification can be reduced. Therefore, the resin composition according to the present invention is an optimum sealing resin for sealing a photovoltaic element, a photosensor and a display element which must be stable for a long time.

The sealing material according to the present invention is formed on the photoelectric conversion surface or the non-photoelectric conversion surface of the photovoltaic element or the like by a method comprising dipping the photovoltaic element into a fluid or a solution of the resin composition according to the present invention, ejecting it, and using proper hardening means selected from a group consisting of heat, light and electron beams. As an alternative to this, a coating method using a roll coat, a kiss coat, a spray coat or electrostatic painting may be employed.

The necessity of making the resin composition formed on the photoelectric conversion surface and that formed on the non-photoelectric conversion surface of the photovoltaic element or the like to be the same may be eliminated. Even if they are different from each other to be adaptable to the form of the solar cell or the like, the effects of the present invention can be obtained satisfactorily. A multi-layer sealing structure may be employed in which glass, ethylene-tetrafluoroethylene film or a metal plate (a back support plate) or the like is stacked on the sealing resin according to the present invention to be adaptable to the way of use of the solar cell or the like. In this case, the effects of the present invention can be obtained satisfactorily. A multi-layer sealing structure in which another resin layer is formed between the photovoltaic element and the sealing resin according to the present invention may be employed.

Since another resin composition according to the present invention contains light transmissive particles as well as the resin, a surface tension and a mutual effect are generated between the resin and the particles. Further, the foregoing particles enables a spacer-like effect to be obtained.

Usually, the solar cell is structured so that a layer made of thin crystal foil or metal foil is formed on a supporting member thereof. Further, a collecting electrode such as a grid, a bus bar or a back electrode is sometimes disposed on the surface of the solar cell. As a result, the portions of the solar cell to be covered have many fine projections and pits, for example, those in the supporting member, those in the peripheral edge portions of each layer, and those in the collecting electrode portion. When fine projection and pits of the foregoing type are sealed by only the resin, there is a tendency that the thickness of the sealing material film becomes too thin in the edge portions of the projections and pits and only a sealing film having many pinholes can be obtained due to the surface tension of the resin and the speciality of the manufacturing process for covering the solar cell.

According to the present invention, the resin can be fit to the edges of the projections and pits due to the surface tension between the foregoing resin and particles, the mutual effect and the spacerlike effect of the particles. Therefore, thinning of the film in the edge portion can be prevented. That is, the levelling characteristics can be improved and, accordingly, a precise film in which the pinholes can be reduced can be formed. As a result, the foregoing objects can be realized.

The present invention is also featured by a fact that the proportion of the resin content is 1.5 times or more the quantity of oil absorbed into a transmissive particles. The quantity of oil absorbed in the particles is a parameter of a quantity with which the space between particles of the light transmissive particles is filled with the resin. The composition of the resion content equivalent to the quantity of the oil absorption is an aimed condition with which a film having no gap can be formed. According to the knowledge found by the inventors, the quantity equivalent to the oil absorption is insufficient to obtain satisfactory physical properties in a special way of usage, that is, sealing a solar cell. By using a large quantity of the resin which is 1.5 times or more the quantity of the absorbed oil, a significantly excellent effect can be obtained. The reason for this is estimated that, if the quantity of the resin is too small, resin regions cannot be formed sufficiently and, accordingly, partciles are in direct contact with one another. If a large quantity of the resin is used, the spaces between light transmissive particles are sufficiently filled with the resin. Therefore, the subject region is enabled to have a sufficient volume to serve as the composite material.

In a case where a low molecular weight hardening resin and a thermoplastic resin having a number averave molecular weight larger than the number average molecular weight of the hardening resin and soluble in the hardening resin are used together, a state is realized in which the relatively high molecular weight thermoplastic resin is equally dispersed in the hardening resin in the micron order or equally dissolved in the same in the molecule level. As a result, the advantages of the hardening resin, that is, excellent heat resistance, damage resistance, water and moisture resistance, and the electric insulation can be maintained. Further, the following disadvantages of the hardening resin can be significantly improved: it is too brittle and impact resistance is unsatisfactory, the adhesivity is limited to some kinds of materials and separation easily takes place, cracks and separation occur due to light deterioration and deterioration in the light transmissivity easily takes place, its poor flexibility causes the mechanical impact and the temperature impact to be made unsatisfactory and it is easily made brittle although the temperature is not high. As a result, the foregoing objects can be further satisfactorily achieve.

The hardening resin for use in the present invention is a resin of a type which is hardened when it is supplied with heat or active energy rays. For example, it is unsaturated polyester resin, phenol resin, alkyd resin, unsaturated acrylic resin, epoxy resin, urethane resin, melamine resin, diaryl phthalate resin, their oligomers and denatured substances. The foregoing materials may be used solely or combined with each other to obtain desired effects.

The thermoplastic resin for use in the present invention is exemplified by saturated polyester resin, phenol resin, acrylic resin, styrene resin, epoxy resin, urethane resin, vinyl acetate resin, vinyl chloride resin, vinyl alcohol resin, acetal resin, their denatured resin and their copolymerized resin. Any one of the foregoing materials may be used solely or they may be combined with each other to obtain desired effects.

In this case, at least a resin selected from the foregoing group consisting of the hardening resins and the thermoplastic resins is contained. That is, the hardening resin and/or the thermoplastic resin may be used.

In the case where the hardening resin and the thermoplastic resin are used together in such a manner that the hardening resin having reactivity and a low molecular weight is used and the thermoplastic resin having a number average molecular weight larger than the number average molecular weight of the hardening resin and soluble in the hardening resin is used, the foregoing state can be realized in which the thermoplastic resin is equally dispersed or dissolved in the hardening resin. Therefore, the disadvantages of the hardening resin can be overcome by the thermoplastic resin while maintaining the advantages of the hardening resin. Therefore, the overall characteristics can significantly be improved.

In this case, the hardening resin of a type having a low molecular weight is employed. That is, the hardening resin must have a small molecular weight with which the thermoplastic resin can be satisfactorily dissolved while preventing occurrence of separation and a desired effect can be obtained from the thermoplastic resin. Although the optimum molecular weight depends upon the conditions, it is preferable that the number average molecular weight (standard polystyrene is made standard) is 3000 or less in the gel permeation chromatogram, more preferably 200 or more to 3000 or less.

The thermoplastic resin for use in this case must have a number average molecular weight larger than the number average molecular weight of the hardening resin and soluble in the hardening resin. If the number average molecular weight is too small, the length of the molecular is too short to obtain a desired reinforcing effect although the soluble quantity into the hardening resin can be enlarged. Although the optimum molecular weight depends upon the conditions the molecular weight (standard polystyrene is made standard) is 5000 or more in the gel permeation chromatogram, with an upper limit of 50000. As for the molecular form of the thermoplastic resin, excellent effect was obtained in the characteristics when a form is employed which includes small number or branched structures and includes a straight-chain bonding structure. The fact that the thermoplastic resin is soluble in the hardening resin means a state where a relatively high molecular thermoplastic resin can be equally dispersed in micron orders or equally dissolved in a molecular level in the hardening resin. From the optical viewpoint, it is defined by an equally dispersed and somewhat turbid state in micron orders or an euqally mixed and transparent state in a molecular level.

The hardening resin is a polymer having an acrylic group or an acrylic group which comprises a substituent at the position α or β and the thermoplastic resin is preferably a styrene-type polymer. In this state, the compatibility between the hardening resin and the thermoplastic resin enables the thermoplastic resin is surrounded by the hardening resin in an extremely satisfactory state (an assumption is made that molecules of the thermoplastic resin are expanded straightly while preventing formation of a pill of molecules) so that an excellent resin composition for sealing a solar cell is obtained.

The polymer having an acrylic group or an acrylic group which comprises a substituent at the position α or β is exemplified by acrylate oligomer, acrylate polymer, methacrylate oligomer, methacrylate polymer, acrylate epoxy oligomer, acrylate epoxy polymer, methacrylate epoxy oligomer, methacrylate epoxy polymer, acrylate urethane oligomer, acrylate urethane polymer, methacrylate urethane oligomer, methacrylate urethane polymer, acrylate melamine oligomer, acrylate melamine polymer, methacrylate melamine oligomer and methacrylate melamine polymer and the like. The foregoing material may be used solely or may be combined at the time of use.

The styrene-type polymer in the foregoing state is a polymer obtained by using one or more polymers of styrene and styrene derivatives. It is exemplified by styrene homopolymer, styrene-butadiene copolymer, styrene-acrylnitril copolymer and styrene-butadiene-acrylnitril copolymer.

As an alternative to using the styrene-type polymer as the thermoplastic resin in the foregoing state, acrylic-type polymer may be employed to realize the excellent compatibility required to obtain the excellent effect. The acrylic-type polymer is exemplified by polymer obtained by using one or more material selected from a group consisting of acrylic acid, acrylic ester, their derivative (methacrylic acid and methacrylic ester included) and a copolymer obtaining by main using the foregoing monomer. It is exemplified by polymers such as acrylic ester homopolymer, acrylic ester copolymer, acrylic acid-acrylic ester copolymer, methacrylic ester homopolymer, methacrylic ester copolymer, methacrylic acid-methacrylic ester copolymer, methacrylic acid-acrylic ester copolymer, acrylic acid-methacrylic ester copolymer, methacrylic acid-acrylic ester copolymer, methacrylic acid-acrylic acid-methacrylic ester copolymer and methacrylic acid-acrylic acid-methacrylic ester-acrylic acid ester copolymer.

As an alternative to using the styrene-type polymer as the thermoplastic resin in the foregoing state, styrene-acryl-type polymer may be employed to realize the excellent compatibility required to obtain the excellent effect. The styrene-acryl-type polymer is a copolymer using one or more materials selected from acrylic acid, acrylic ester and their derivatives or a copolymer mainly using the foregoing monomer. It is exemplified by styrene-acrylic ester copolymer, styrene-acrylic acid-acrylic ester copolymer, styrene-methacrylic ester copolymer, styrene-methacrylic acid-methacrylic ester copolymer, styrene-methacrylic acid-acrylic ester copolymer, styrene-acrylic acid-methacrylic ester copolymer, styrene-methacrylic acid-acrylic acid-acrylic ester copolymer, styrene-methacrylic acid-acrylic acid-methacrylic ester copolymer and styrene-methacrylic acid-acrylic acid-methacrylic ester-acrylic ester copolymer.

The foregoing acrylic ester is exemplified by a monomer such as methyl acrylate, ethyl acrylate, propyl acrylate, butyl acrylate, octyl acrylate, dodecyl acrylate and hexadecyl acrylate. The derivatives of the acrylic ester are exemplified by a monomer such as acrylic acid dihydroperfluorobutyl and a monomer obtained by introducing a substituent into the foregoing monomer.

The methacrylic ester is exmplified by a monomer such as methyl methacrylate, ethyl methacrylate, propyl methacrylate, isopropyl methacrylate, butyl methacrylate, sec-butyl methacrylate, tert-butyl methacrylate, isobutyl methacrylate, aryl methacrylate, phenyl methacrylate and benzyl methacrylate. The derivative of the methacrylic ester is exemplified by a monomer obtained by introducing a substituent into the foregoing monomer.

In the case where the hardening resin and the thermoplastic resin are used together, a predetermined method for solving the thermoplastic resin into the hardening resin may be employed. For example, a method may be employed in which the thermoplastic resin is directly dissolved into the hardening resin while stirring the thermoplastic resin and a method may be employed in which both of the foregoing resins are dissolved in an organic solvent such as toluene, alcohol, ketone or ester.

The light transmissive particles for use in the present invention may be polymer particles of polyester resin, phenol resin, acrylic resin, styrene resin, epoxy resin, urethane resin, melamine resin, silicon resin, their denatured resin or their copolymer resin; metal oxide particles of titanium oxide, silicon oxide, zinc oxide, tin oxide or aluminum oxide; carbonic salt particles of lithium carbonate, calcium carbonate, strontium carbonate, barium carbonate or aluminum carbonate; glass-type particles of glass or quartz; and elastic rubber particles of urethane rubber, ethylene propylene rubber, fluorine-type rubber and silicone rubber. However, the present invention is not limited to the description above.

The foregoing particles have light transmissivity. The light transmissivity may be determined depending upon the difference in the refraction factor between the employed hardening resin, the thermoplastic resin and the particles. It is not defined by the optical characteristics of the particles. That is, the light transmissivity of the particles may be a level which does not deteriorate the characteristics of the solar cell as the sealing film formed by the resin composition composed of the hardening resin, thermoplastic resin and the light transmissive particles. It is preferable that the particles have a light transmissivity with which a total diffusion transmissivity of 85% is realized except the optical loss occurring due to the surface reflection of the sealing film, more preferably the total diffusion transmissivity of 93% or more.

The shape of the light transmissive particle is not limited particularly in the present invention. However, in order to reduce the optical loss and to facilitate filling of the particles, it is preferable that the particles is in the form of spheres, sphere-like shapes each having a smooth surface but having slight projections and pits, ellipses, or ellipse-like shapes each having a smooth surface but having slight projections and pits. If the particles are in any of the foregoing shape, it is preferable that the average particle size of the particles is about 0.01 to 100 µm.

If very hard particles such as glass beads or quartz beads are used as the light transmissive particles, an advantage can be obtained in that the excellent hardness of the foregoing material is further given to the sealing material.

If titanium oxide, silicon oxide, zinc oxide, tin oxide or aluminum oxide is used as the light transmissive particles, bonding are established between the particles and the resin to be nodes. As a result, a 3-D structure can be developed, causing the other advantages to be obtained in that the strength can be reinforced, the heat resistance can be improved and the tenacity can be improved.

If particles made of elastic rubber, for example, urethane rubber particles, ethylene propylene rubber particles, fluorine-type rubber particles or silicone rubber particles are employed as the light transmissive particles, the other advantages can be obtained in that the flexibility can be improved and the tenacity can be improved.

Ultra-fine particles of sub-micron order or finer may be used as the light transmissive particles. When such ultra-fine particles are used, it is possible to effectively cut light rays of short wavelengths less than 400 nm, so as to diminish degradation of the sealing material due to irradiation by light, thus improving weather resistance advantageously.

In the present invention, the proportion of the contents of the hardening resin and the thermoplastic resin is 1.5 times or more of the quantity of oil absorbed by the light transmissive particles. The quantity of the absorbed oil was measured while conforming to JIS K5101. As described above, the present invention has the arrangement that a large quantity of resin with respect to the oil absorbed in the particles is contained. Therefore, the spaces between the particles are sufficiently filled with the resin and, accordingly, an excellent effect can be obtained.

The method of forming the resin composition according to the present invention on the photoelectric conversion surface or the non-photoelectric conversion surface of the solar cell may be performed in such a manner that the solar cell is dipped in a resin composition fluid or its solution before ejecting the solar cell, and the resin composition is hardened by using a hardening means such as heat, light, electron beams applied to the same. As an alternative to this, a proper coating method may be employed, for example, a roll coat, a kiss coat, a spray coat and electrostatic painting.

As the hardening means, a polymerization initiator such as alkylperoxy ester, dialkylperoxide, peroxyketal or peroxydicarbonate and or light polymerization initiator may be used while heating, applying light or electron beams to it. If necessary, a compound so-called a reactive monomer serving as the polymerization initiator, for example, hexamethylene acrylate, trimethylol propane triacrylate, may be added.

In the case where both polymer (the hardening resin) having a polymerizable and unsaturated acrylic group having reactivity and a light molecular weight and the styrene-type polymer, acryl-type polymer or styrene-acryl type polymer (the thermoplastic resin) having a number average molecular weight larger than the number average molecular weight of the hardening resin and soluble in the hardening resin are used as the resins, an excellent effect can be obtained in that the polymerization initiator does not need to be used or the quantity of the same can significantly be reduced. As a result, a problem caused from use of the polymerization initiator can be overcome or reduced. That is, the following effects are obtained: an excellent light transmissivity can be obtained, a yellow color change zone due to light can be reduced, and the deterioration in the mechanical and optical physical properties such as the deteriorations in the strength and the devitrification can be prevented. Therefore, the foregoing material is optimum to form a resin for sealing a solar cell which must be used stably for a long time.

In the case where the resin composition according to the present invention seals the solar cell, the necessity of making the resin composition formed on the photoelectric conversion surface of the solar cell and that formed on the non-photoelectric conversion surface to be the same may be eliminated. They may be different from each other to be adaptable to the shape and the purpose of the solar cell. A multi-layer sealing structure may be employed in which glass, ethylene-tetrafluoroethylene film or a metal plate (a back support plate) or the like is stacked on the sealing resin according to the present invention. A multi-layer sealing structure in which another resin layer is formed between the solar cell and the sealing resin may be employed. Specifically, a structure may be employed in which a glass or resin thin film is formed on the outermost surface of each of the photoelectric conversion surface and the non-photoelectric conversion surface of the solar cell, and a protection layer made of the resin composition according to the present invention is formed in the inner layer.

Then, examples of the present invention will now be described.

The evaluation items shown in Table 10 relating to Examples 10 to 18 and Comparative Examples 10 to 18 were obtained as follows.

Initial conversion efficiency: the conversion efficiency of a solar cell immediate after it has been manufactured was measured.

Weather resistance: the conversion efficiency after a weathering test had been performed for 1000 hours by using a sunshine weather meter was measured.

Surface hardness: it was measured while conforming to JIS 5400 (pencil test).

Damage resistance: a damage was made by using a sharp article to evaluate as follows:
- ○:: no abnormality was found
- Δ:: a slight damage was found
- X:: a damage can be found

High temperature and high humidity deterioration test: the conversion efficient was measured after the sample was allowed to stand at a temperature of 85°C and a humidity of 85 RH% for 100 hours.

Flexibility: It was evaluated by a method conforming to JIS Z2248 in accordance with the following criteria:
- ○:: no abnormality was found
- Δ:: a slight damage was found
- X:: a damage was found

### Example 1

By diffusing gas phase POCl₃ in a p-type silicon wafer having a thickness of 0.2 mm, a pn junction having a p-type silicon single crystal la and an n⁺-type layer 1b was formed. Aluminum was evaporated on the entire surface of the p-layer, so that a backside electrode 2 was formed. Silver paste having a width of 200 µm was sintered on the n-layer at intervals of 5 mm, so that a surface electrode 3 was formed. As a result, a photovoltaic element was formed.

50 parts of acrylate ester oligomer having a number average molecular weight of 400 and 20 parts of styrene resin composed of styrene monomer having a number average molecular weight of 15000 were dissolved in 30 parts of methylethylketone so that an equal solution having a viscosity of 100 CPS was prepared.

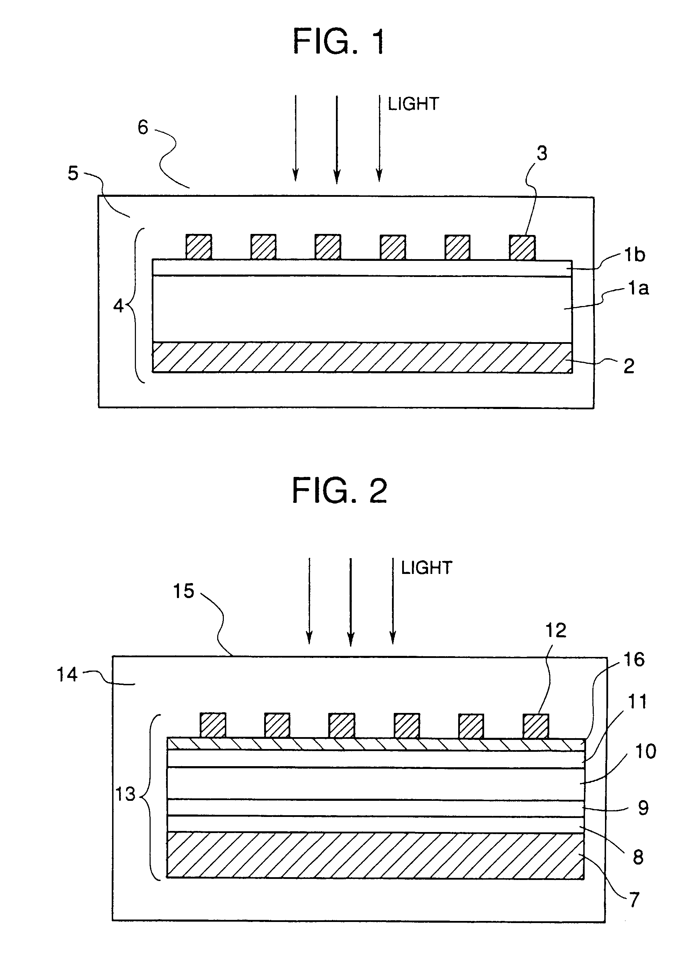

The photovoltaic element 4 was dipped in the foregoing solution, ejected from the same, and heated at 100°C for 20 minutes to be dried. Then, it was, for 30 seconds, irradiated with light of 365 nm and an illuminance of 50 mW/cm² emitted from a high voltage mercury lamp. As a result, a hard resin film having a thickness of 40 µm was formed on the entire surface. The foregoing process was further performed two times to seal the photovoltaic element 4 with a hard resin film 5 having a total thickness of 120 µm. As a result, a solar cell 6 similar to that shown in Fig. 1 was manufactured.

### Comparative Example 1

50 parts of unsaturated polyester having a number average molecular weight of 1000, two parts of dicumyl peroxide and 20 parts of the styrene resin according to Example 1 were dissolved in 28 parts of methylethylketone, so that an equal solution having a viscosity of 90 CPS was prepared.

The photovoltaic element 4 was dipped in the foregoing solution, ejected from the same, and heated at 150°C for 30 minutes to be dried. As a result, a hard resin film having a thickness of 40 µm was formed on the entire surface. The foregoing process was further performed two times, so that a hard resin film having a total thickness of 120 µm was formed.

By subjecting the solar cells thus manufactured to a sunshine weather meter, the photoelectric conversion characteristics and the characteristics of the sealing material were evaluated in such a manner that the initial characteristics and those realized after 1000 hours had passed were subjected to a comparison. The results are shown in Table 1.

**Table 1**

| | Example 1 | Comparative Example 1 |
|---|---|---|
| Characteristics of solar cell | | |
| Initial conversion efficiency | 13.3% | 12.5% |
| | | |
| Conversion efficiency after 1000 hours had passed with sunshine weather meter | 12.0% | 10.5% |
| Initial characteristics of sealing material | | |
| | | |
| Surface hardness | 4 H | 3 H |
| | | |
| Total light transmissivity | 93% | 89% |
| | | |
| Adhesivity (cross hatching test) | 100/100 | 100/100 |
| Characteristics of sealing material after 1000 hours had passed with sunshine weather meter | | |
| | | |
| Surface hardness | 4 H | 2 H |
| | | |
| Total light transmissivity | 86% | 75% |
| | | |
| Adhesivity (cross hatching test) | 100/100 | 85/100 |

### Example 2

A Cr layer 8 having a thickness of 2000 Å (10Å=1nm) was deposited on a SUS 430 substrate 7 having a thickness of 1 mm by a DC sputtering method. Then, an n-type semiconductor 9 having a thickness of 500 Å was formed under conditions that the proportion of SiH₄ gas/PH₃ gas was 99.98/0.02, the pressure was 1 Torr (1 Torr=133.32 Pa) and RF power was 100 W. Then, an i-type semiconductor 10 having a thickness of 5000 Å was deposited under conditions that the proportion of SiH₄ gas/H₂ gas was 30/70, the pressure was 1.5 Torr and RF power was 50 W. Then, a p-type semicondudtor 11 having a thickness of 200 Å was deposited under conditions that the proportion of SiH₄ gas/H₂ gas/BF₃ gas was 3/96.7/0.3, the pressure was 1.2 Torr and RF power was 1 KW. As a result of the above sequential depositions, a semiconductor layer having a pin junction was formed. Then, In was evaporated on the surface under condition that the O₂ gas pressure was 0.5 Torr, so that a transparent conductive film 16 having a thickness of 700 Å was formed. Silver paste having a width of 200 µm was formed at intervals of 5 mm, so that a collecting electrode 12 was formed to be made an amorphous silicon photovoltaic element 13.

50 parts of acrylate epoxy oligomer having a number average molecular weight of 600 and 20 parts of styrene resin composed of styrene·butadiene monomer having a number average molecular weight of 8000 (monomer composition 80 parts/20 parts) were dissolved in 30 parts of ethyl acetate ester so that an equal solution having a viscosity of 150 was prepared.

The amorphous silicon photovoltaic element 13 was dipped in the foregoing solution, ejected from the same, and heated at 100°C for 20 minutes to be dried. As a result, a hard resin film having a thickness of 40 µm was formed on the entire surface. The foregoing process was further performed two times to seal the amorphous silicon photovoltaic element 13 with a hard resin film 14 having a total thickness of 120 µm. As a result, a solar cell 6 similar to that shown in Fig. 2 was manufactured.

### Comparative Example 2

50 parts of heat hardening phenol resin having a number average molecular weight of 600 and 20 parts of thermoplastic acrylic resin having an average molecular weight of 3000 were dissolved in 30 parts of methylethylketone so that an equal solution having a viscosity of 80 CPS was prepared.

The photovoltaic element of Example 2 was dipped in the foregoing solution and ejected from the same. Then, it was heated at 150°C for 30 minutes to be dried so that a hard resin film having a thickness of 40 µm was formed on the entire surface. The foregoing process was repeated further 2 times so that a hard resin film having a total thickness of 120 µm was formed.

By subjecting the solar cells thus manufactured to a sunshine weather meter, the photoelectric conversion characteristics and the characteristics of the sealing material were evaluated in such a manner that the initial characteristics and those realized after 1000 hours had passed were subjected to a comparison. The results are shown in Table 2.

**Table 2**

| | Example 2 | Comparative Example 2 |
|---|---|---|
| Characteristics of solar cell | | |
| | | |
| Initial conversion efficiency | 6.2% | 5.6% |
| | | |
| Conversion efficiency after 1000 hours had passed with sunshine weather meter | 5.4% | 4.4% |
| | | |
| Initial characteristics of sealing material | | |
| | | |
| Surface hardness | 3 H | 3 H |
| | | |
| Total light transmissivity | 92% | 85% |
| | | |
| Adhesivity (cross hatching test) | 100/100 | 90/100 |
| | | |
| Characteristics of sealing material after 1000 hours had passed with sunshine weather meter | | |
| | | |
| Surface hardness | 3 H | H |
| | | |
| Total light transmissivity | 85% | 70% |
| | | |
| Adhesivity (cross hatching test) | 100/100 | 60/100 |
| | | |
| Adhesivity after allowing to stand at 50°C and 100%RH for 500 hours | 100/100 | 65/100 |

### Example 3

50 parts of acrylate urethane oligomer having a number average molecular weight of 200 and 15 parts of styrene resin composed of styrene monomer having a number average molecular weight of 20000 were dissolved in 35 parts of toluene so that an equal solution having a viscosity of 250 CPS was prepared.

The photovoltaic element according to Example 2 was dipped in the foregoing solution, ejected from the same, and heated at 100°C for 20 minutes to be dried. Then, it was, for 30 seconds, irradiated with light of 365 nm and an illuminance of 50 mW/cm² emitted from a high voltage mercury lamp. As a result, a resin composition film having a thickness of 40 µm was formed on the entire surface.

The foregoing process was further performed two times to seal the photovoltaic element with the resin composition film having a total thickness of 120 µm, so that a solar cell similar to that shown in Fig. 1 was manufactured.

### Comparative Example 3

50 parts of diaryl phthalate resin having a number average molecular weight of 1000, two parts of di-t-butylperoxide and 15 parts of the styrene resin according to Example 2 were dissolved in 35 parts of toluene, so that an equal solution having a viscosity of 180 CPS was prepared.

The photovoltaic element according to Example 2 was dipped in the foregoing solution, ejected from the same, and heated at 150°C for 30 minutes to be dried. As a result, a hard resin film having a thickness of 40 µm was formed on the entire surface. The foregoing process was further performed two times, so that a hard resin film having a total thickness of 120 µm was formed.

By subjecting the solar cells thus manufactured to a sunshine weather meter, the photoelectric conversion characteristics and the characteristics of the sealing material were evaluated in such a manner that the initial characteristics and those realized after 1000 hours had passed were subjected to a comparison. The results are shown in Table 3.

**Table 3**

| | Example 3 | Comparative Example 3 |
|---|---|---|
| Characteristics of solar cell | | |
| | | |
| Initial conversion efficiency | 6.2% | 5.3% |
| | | |
| Conversion efficiency after 1000 hours had passed with sunshine weather meter | 5.4% | 4.4% |
| Initial characteristics of sealing material | | |
| | | |
| Surface hardness | 6 H | 6 H |
| | | |
| Total light transmissivity | 93% | 80% |
| | | |
| Adhesivity (cross hatching test) | 100/100 | 70/100 |
| Characteristics of sealing material after 1000 hours had passed with sunshine weather meter | | |
| | | |
| Surface hardness | 5 H | 2 H |
| | | |
| Total light transmissivity | 86% | 69% |
| | | |
| Adhesivity (cross hatching test) | 100/100 | 40/100 |
| Adhesivity after allowing to stand at 50°C and 100%RH for 500 hours | 100/100 | 40/100 |

As can be clearly seen from the results shown in Tables 1 to 3, the solar cell according to the present invention exhibits excellent photoelectrical conversion characteristics. Further, a fact was found that the initial excellent conversion efficiency can be maintained even after the sunshine weather meter test simulated to the actual use was conducted.

### Example 4

By diffusing gas phase POCl₃ in a p-type silicon wafer having a thickness of 0.2 mm, a pn junction having a p-type silicon single crystal la and an n⁺-type layer 1b was formed. Aluminum was evaporated on the entire surface of the p-layer, so that a backside electrode 2 was formed. Silver paste having a width of 200 µm was sintered on the n-layer at intervals of 5 mm, so that a surface electrode 3 was formed. As a result, a photovoltaic element 4 was formed.

50 parts of acrylate ester oligomer having a number average molecular weight of 400 and 20 parts of acrylic resin composed of a monomer (monomer composition 30 parts/60 parts/10 parts) of methyl methacrylate ester· butyl methacrylate ester·acrylic acid were dissolved in 30 parts methylethylketone so that an equal solution having a viscosity of 100 CPS was prepared.

The photovoltaic element 4 was dipped in the foregoing solution, ejected from the same, and heated at 100°C for 20 minutes to be drived. Then, it was, for 30 seconds, irradiated with light of 365 nm and an illuminance of 50 mW/cm² emitted from a high voltage mercury lamp. As a result, a hard resin film having a thickness of 40 µm was formed on the entire surface. The foregoing process was further performed two times to seal the photovoltaic element 4 with a hard resin film 5 having a total thickness of 120 µm. As a result, a solar cell similar to that shown in Fig. 1 was manufactured.

### Comparative Example 4

50 parts of unsaturated polyester having a number average molecular weight of 1000, two parts of dicumyl peroxide and 20 parts of the acrylic resin according to Example 4 were dissolved in 28 parts of methylethylketone, so that an equal solution having a viscosity of 90 CPS was prepared.

The photovoltaic element 4 according to Example 4 was dipped in the foregoing solution, ejected from the same, and heated at 150°C for 30 minutes to be dried. As a result, a hard resin film 5 having a thickness of 40 µm was formed on the entire surface. The foregoing process was further performed two times, so that a hard resin film 5 having a total thickness of 120 µm was formed.

By subjecting the solar cells 6 thus manufactured to a sunshine weather meter, the photoelectric conversion characteristics and the characteristics of the sealing material were evaluated in such a manner that the initial characteristics and those realized after 1000 hours had passed were subjected to a comparison. The results are shown in Table 4.

**Table 4**

| | Example 4 | Comparative Example 4 |
|---|---|---|
| Characteristics of solar cell | | |
| | | |
| Initial conversion efficiency | 13% | 12.5% |
| | | |
| Conversion efficiency after 1000 hours had passed with sunshine weather meter | 12.3% | 11% |
| Initial characteristics of sealing material | | |
| | | |
| Surface hardness | 5 H | 4 H |
| | | |
| Total light transmissivity | 93% | 89% |
| | | |
| Adhesivity (cross hatching test) | 100/100 | 100/100 |
| Characteristics of sealing material after 1000 hours had passed with sunshine weather meter | | |
| | | |
| Surface hardness | 5 H | 3 H |
| | | |
| Total light transmissivity | 88% | 78% |
| | | |
| Adhesivity (cross hatching test) | 100/100 | 85/100 |

### Example 5

A Cr layer 8 having a thickness of 2000 Å was deposited on a SUS 430 substrate 7 having a thickness of 1 mm by a DC sputtering method. Then, an n-type semiconductor 9 having a thickness of 500 Å was, by an RF plasma CVD method, formed under conditions that the proportion of SiH₄ gas/PH₃ gas was 99.98/0.02, the pressure was 1 Torr and RF power was 100 W. Then, an i-type semiconductor 10 having a thickness of 5000 Å was deposited under conditions that the proportion of SiH₄ gas/H₂ gas was 30/70, the pressure was 1.5 Torr and RF power was 50 W. Then, a p-type semiconductor 11 having a thickness of 200 Å was deposited under conditions that the proportion of SiH₄ gas/H₂ gas/BF₃ gas was 3/96.7/0.3, the pressure was 1.2 Torr and RF power was 1 KW. As a result of the above sequential depositions, a semiconductor layer having a pin junction was formed. Then, In was evaporated on the surface under condition that the O₂ gas pressure was 0.5 Torr, so that a transparent conductive film 16 having a thickness of 700 Å was formed. Silver paste having a width of 200 µm was formed at intervals of 5 mm, so that a collecting electrode was formed to be made an amorphous silicon photovoltaic element 13.

50 parts of acrylate epoxy oligomer having a number average molecular weight of 600 and 20 parts of acrylic resin composed of monomer (monomer composition 50 parts/35 parts/15 parts) of methylacrylate ester having a number average molecular weight of 15000, butylmethacrylate ester and methacrylic acid were dissolved in 30 parts of methyl acetate ester so that an equal solution having a viscosity of 150 was prepared.

The amorphous silicon photovoltaic element 13 was dipped in the foregoing solution, ejected from the same, and heated at 100°C for 20 minutes to be dried. Then, it was, for 30 seconds, irradiated with light of 365 nm and an illuminance of 50 mW/cm² emitted from a high voltage mercury lamp. As a result, a hard resin film having a thickness of 40 µm was formed on the entire surface. The foregoing process was further performed two times to seal the photovoltaic element 13 with a hard resin film 14 having a total thickness of 120 µm. As a result, a solar cell 6 similar to that shown in Fig. 2 was manufactured.

### Comparative Example 5

50 parts of heat hardening phenol resin having a number average molecular weight and 20 parts of thermoplastic acrylic resin having a number average molecular weight of 3000 were dissolved in 30 parts of methylethyl ketone so that an equal solution having a viscosity of 100 CPS was prepared.

The amorphous silicon photovoltaic element according to Example 5 was dissolved in the foregoing solution and ejected from it. Then, it was heated at 150°C for 30 minutes to be dried, so that a hard resin film having a thickness of 40 µm was formed on the entire surface. The foregoing process was further repeated two times so that a hard resin film having a total thickness of 120 µm was formed.

By subjecting the solar cells thus manufactured to a sunshine weather meter, the photoelectric conversion characteristics and the characteristics of the sealing material were evaluated in such a manner that the initial characteristics and those realized after 1000 hours had passed were subjected to a comparison. The results are shown in Table 5.

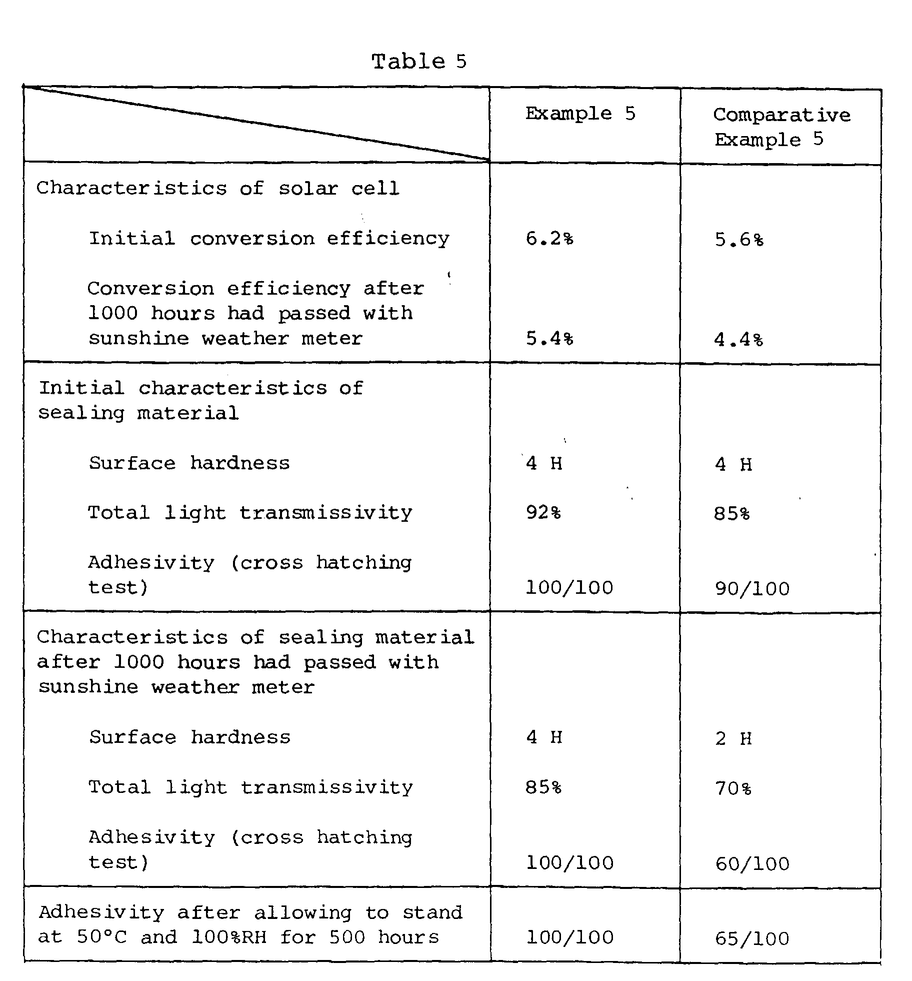

### Example 6

50 parts of acrylate urethane oligomer having a number average molecular weight of 200 and 15 parts of acrylic resin composed of butyl methacrylate ester having a number average molecular weight of 20000 and methacrylic acid monomer (monomer composition 80 parts/20 parts) were dissolved in 35 parts of toluene so that an equal solution having a viscosity of 120 CPS was prepared.

The photovoltaic element according to Example 5 was dipped in the foregoing solution, ejected from the same, and heated at 100°C for 20 minutes to be dried. Then, it was, for 30 seconds, irradiated with light of 365 nm and an illuminance of 50 mW/cm² emitted from a high voltage mercury lamp. As a result, a resin composition film having a thickness of 40 µm was formed on the entire surface. The foregoing process was further performed two times to seal the photovoltaic element with the hard resin film having a total thickness of 120 µm, so that a solar cell was manufactured.

### Comparative Example 6

50 parts of diaryl phthalate resin having a number average molecular weight of 1000, two parts of di-t-butylperoxide and 15 parts of the acrylic resin according to Example 5 were dissolved in 35 parts of toluene, so that an equal solution having a viscosity of 180 CPS was prepared.

The photovoltaic element according to Example 5 was dipped in the foregoing solution, ejected from the same, and heated at 150°C for 30 minutes to be dried. As result, a hard resin film having a thickness of 40 µm was formed on the entire surface. The foregoing process was further performed two times, so that a hard resin film having a total thickness of 120 µm was formed.

By subjecting the solar cells thus manufactured to a sunshine weather meter, the photoelectric conversion characteristics and the characteristics of the sealing material were evaluated in such a manner that the initial characteristics and those realized after 1000 hours had passed were subjected to a comparison. The results are shown in Table 6.

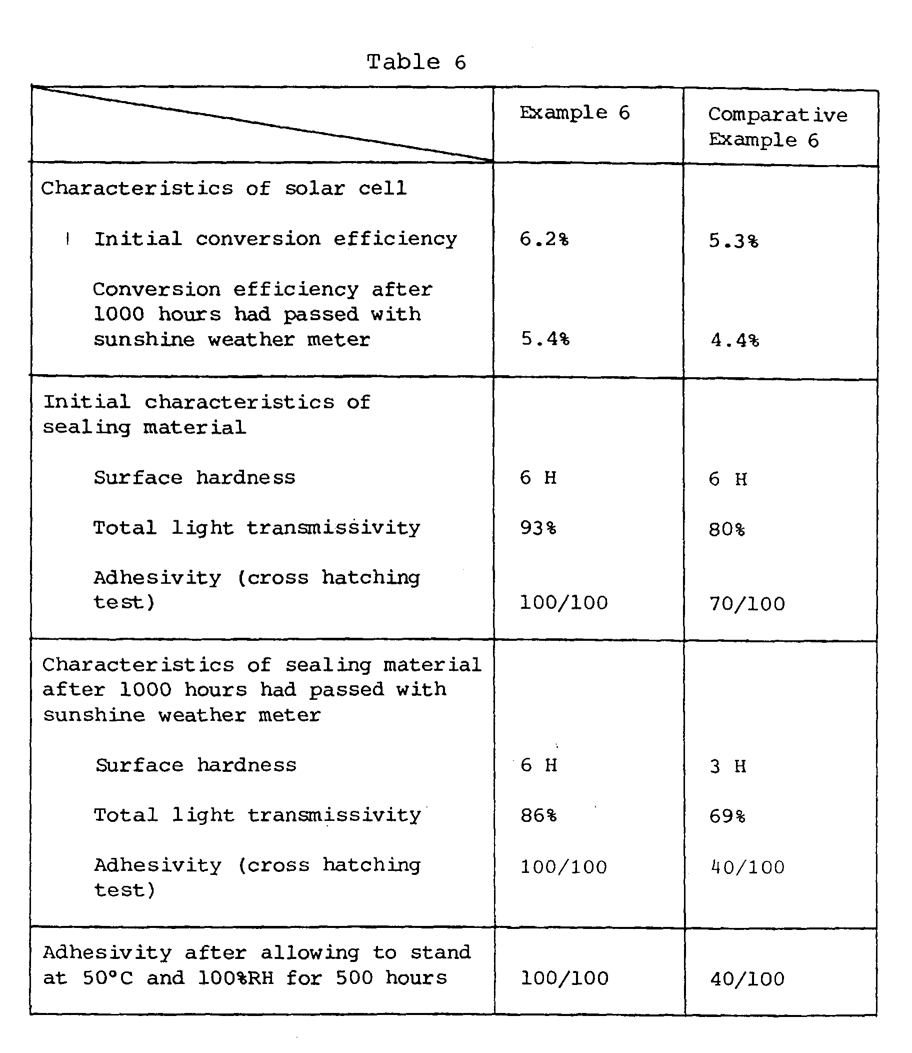

As can be clearly seen from the results shown in Tables 4 to 6, the solar cell according to the present invention exhibits excellent photoelectrical conversion characteristics. Further, a fact was found that the initial excellent conversion efficiency can be maintained even after the sunshine weather meter test simulated to the actual use was conducted.

### Example 7

By diffusing gas phase POCl₃ in a p-type silicon wafer having a thickness of 0.2 mm, a pn junction having a p-type silicon single crystal la and an n⁺-type layer 1b was formed. Aluminum was evaporated on the entire surface of the p-layer, so that a backside electrode 2 was formed. Silver paste having a width of 200 µm was sintered on the n-layer at intervals of 5 mm, so that a surface electrode 3 was formed. As a result, a photovoltaic element 4 was formed.

50 parts of acrylate ester oligomer having a number average molecular weight of 400 and 20 parts of acrylic resin composed of styrene methylmethacrylate ester·butylmethacrylate ester·acrylic acid monomer (monomer composition 20 part/30 parts/40 parts/10 parts) were dissolved in 30 parts methylethyl ketone so that an equal solution having a viscosity of 100 CPS was prepared.

The photovoltaic element 4 was dipped in the foregoing solution, ejected from the same, and heated at 100°C for 20 minutes to be dried. Then, it was, for 30 seconds, irradiated with light of 365 nm and an illuminance of 50 mW/cm² emitted from a high voltage mercury lamp. As a result, a hard resin film having a thickness of 40 µm was formed on the entire surface. The foregoing process was further performed two times to seal the photovoltaic element 4 with a hard resin film 5 having a total thickness of 120 µm. As a result, a solar cell similar to that shown in Fig. 1 was manufactured.

### Comparative Example 7

50 parts of unsaturated polyester having a number average molecular weight of 1000, 2 parts of dicumyl peroxide and 20 parts of the styrene acrylic resin according to Example 7 were dissolved in 28 parts of methylethylketone, so that an equal solution having a viscosity of 90 CPS was prepared.

The photovoltaic element 4 according to Example 7 was dipped in the foregoing solution, ejected from the same, and heated at 150°C for 30 minutes to be dried. As a result, a hard resin film having a thickness of 40 µm was formed on the entire surface. The foregoing process was further performed two times, so that a hard resin film having a total thickness of 120 µm was formed.

By subjecting the solar cells thus manufactures to a sunshine weather meter, the photoelectric conversion characteristics and the characteristics of the sealing material were evaluated in such a manner that the initial characteristics and those realized after 1000 hours had passed were subjected to a comparison. The results are shown in Table 7.

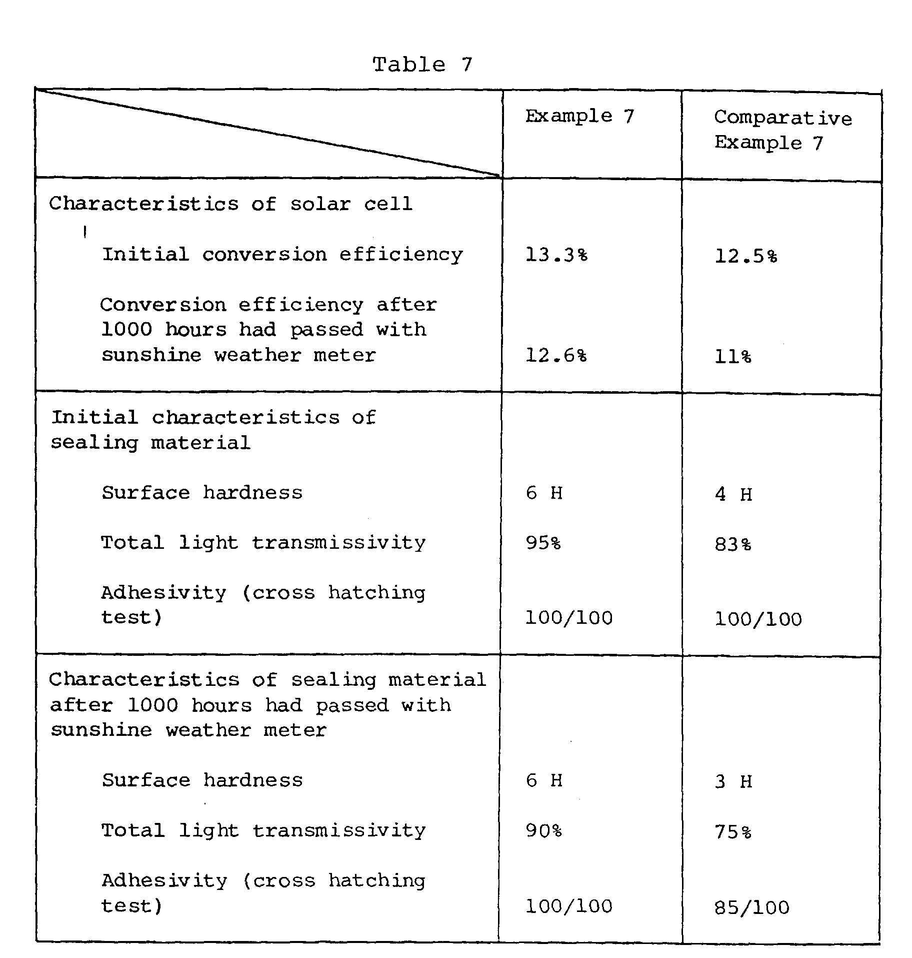

### Example 8

A Cr layer 8 having a thickness of 2000 Å was deposited on a SUS 430 substrate 7 having a thickness of 1 mm by a DC sputtering method. Then, an n-type semiconductor 9 having a thickness of 500 Å was, by a RF plasma CVD method, formed under conditions that the proportion of SiH₄ gas/PH₃ gas was 99.98/0.02, the pressure was 1 Torr and RF power was 100 W. Then, an i-type semiconductor 10 having a thickness of 5000 Å was deposited under conditions that the proportion of SiH₄ gas/H₂ was 30/70, the pressure was 1.5 Torr and RF power was 50 W. Then, a p-type semiconductor 11 having a thickness of 200 Å was deposited under conditions that the proportion of SiH₄ gas/H₂ gas/BF₃ gas was 3/96.7/0.3, the pressure was 1.2 Torr and RF power was 1 KW. As a result of the above sequential depositions, a semiconductor layer having a pin junction was formed. Then, In was evaporated on the surface under condition that the O₂ gas pressure was 0.5 Torr, so that a transparent conductive film 16 having a thickness of 700 Å was formed. Silver paste having a width of 200 µm was formed at intervals of 5 mm, so that a collecting electrode 12 was formed to be made an amorphous silicon photovoltaic element 13.

50 parts of acrylate epoxy oligomer having a number average molecular weight of 600 and 20 parts of acrylic resin (monomer composition 50 parts/35 parts/ 15 parts) of methyl acrylate·butyl methacrylate· methacrylic acid having a number average molecular weight of 15000 were dissolved in 30 parts of ethyl acetate ester so that an equal solution having viscosity of 150 was prepared.

The amorphous silicon photovoltaic element 13 was dipped in the foregoing solution, ejected from the same, and heated at 100°C for 20 minutes to be dried. Then, it was, for 30 seconds, irradiated with light of 365 nm and an illuminance of 50 mW/cm² emitted from a high voltage mercury lamp. As a result, a hard resin film having a thickness of 40 µm was formed on the entire surface. The foregoing process was further performed two times to seal the amorphous silicon photovoltaic element 13 with a hard resin film having a total thickness of 120 µm. As a result, a solar cell similar to that shown in Fig. 2 was manufactured.

### Comparative Example 8

50 parts of heat hardening phenol resin having a number average molecular weight of 600 and 20 parts of acrylic resin according to Example 8 were dissolved in 30 parts of methylethyl ketone so that an equal solution having a viscosity of 100 CPS was prepared.

The photovoltaic element 13 according to Example 8 was dipped in the foregoing solution, ejected from the same, and heated at 150°C for 30 minutes to be dried. As a result, a hard resin film having a thickness of 40 µm was formed on the entire surface. The foregoing process was further performed two times so that a hard resin film having a total thickness of 120 µm was formed.

By subjecting the solar cells thus manufactured to a sunshine weather meter, the photoelectric conversion characteristics and the characteristics of the sealing material were evaluated in such a manner that the initial characteristics and those realized after 1000 hours had passed were subjected to a comparison. The results are shown in Table 8.

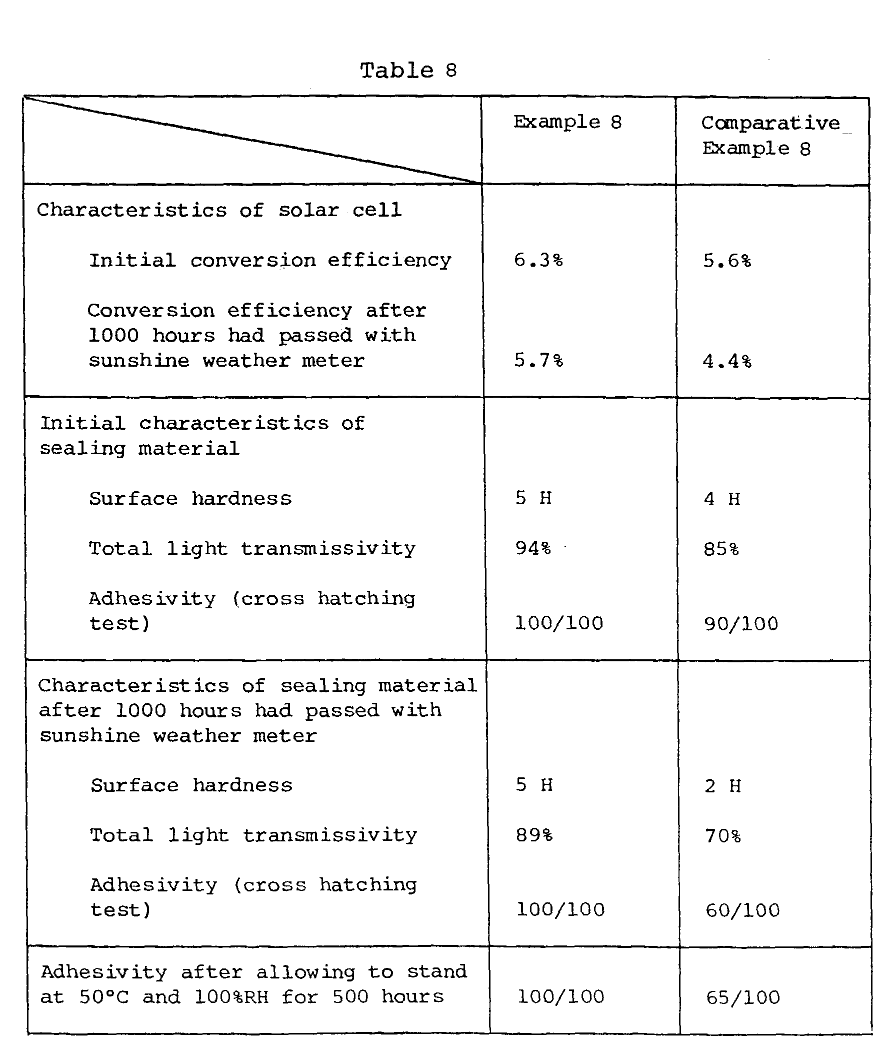

### Example 9

50 parts of acrylate urethane oligomer having a number average molecular weight of 200 and 15 parts of acrylic resin composed of styrene ethyl acrylate ester having a number average molecular weight of 20000 and butyl methacrylate butyl ester and methacrylic monomer (monomer composition 30 parts/30 parts/20 parts/20 parts) were dissolved in 35 parts of toluene, so that an equal solution having a viscosity of 180 CPS was prepared.

The photovoltaic element according to Example 8 was dipped in the foregoing solution, ejected from the same, and heated at 100°C for 20 minutes to be dried. Then, it was, for 30 seconds, irradiated with light of 365 nm and an illuminance of 50 mW/cm² emitted from a high voltage mercury lamp. As a result, a hard resin film having a thickness of 40 µm was formed on the entire surface. The foregoing process was further performed two times to seal the photovoltaic element with a hard resin film having a total thickness of 120 µm. As a result, a solar cell was manufactured.

### Comparative Example 9

50 parts of diarylphthalate resin having a number average molecular weight of 1000, two parts of di-t-butylperoxide and 15 parts of acrylic resin according to Example 8 were dissolved in 35 parts of toluene so that an equal solution having a viscosity of 180 CPS was prepared.

The photovoltaic element according to Example 8 was dipped in the foregoing solution, ejected from the same, and heated at 150°C for 30 minutes to be dried. As a result, a hard resin film having a thickness of 40 µm was formed on the entire surface. The foregoing process was further performed two times, so that a hard resin film having a total thickness of 120 µm was formed.

By subjecting the solar cells thus manufactured to a sunshine weather meter, the photoelectric conversion characteristics and the characteristics of the sealing material were evaluated in such a manner that the initial characteristics and those realized after 1000 hours had passed were subjected to a comparison. The results are shown in Table 9.

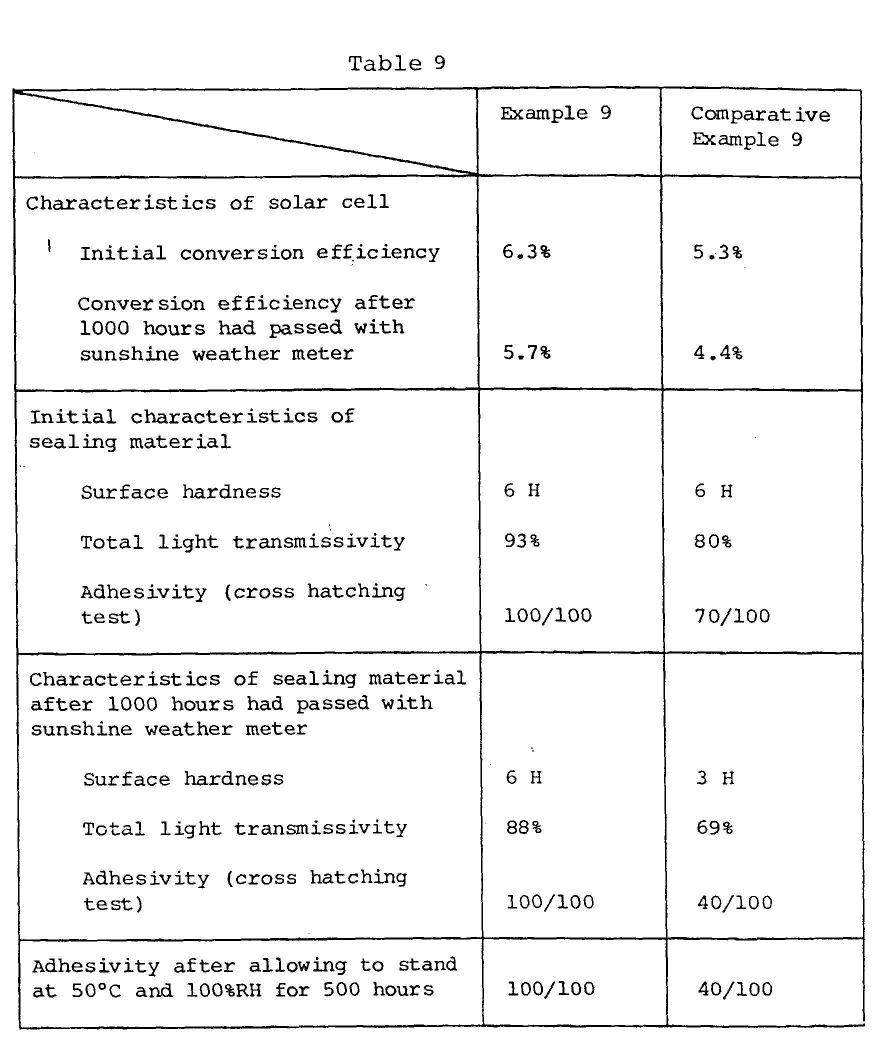

As can be clearly seen from the results shown in Tables 7 to 9, the solar cell according to the present invention exhibits excellent photoelectrical conversion characteristics. Further, a fact was found that the initial excellent conversion efficiency can be maintained even after the sunshine weather meter test simulated to the actual use was conducted.

### Example 10

70 parts by weight of acrylate ester oligomer, the number average molecular weight of which was 400 and which was hardening resin, 30 parts by weight of styrene resin, the number average molecular weight of which was 15000 and which was thermoplastic resin and 100 parts by weight of spherical glass beads, the oil absorption quantity of which was 20 g/100 g, the average particle size of which was 60 µm and which were light transmissive particles were uniformly dissolved and dispersed in 40 parts by weight of methylethyl ketone. As a result, a dispersed solution of the resin composition was obtained.

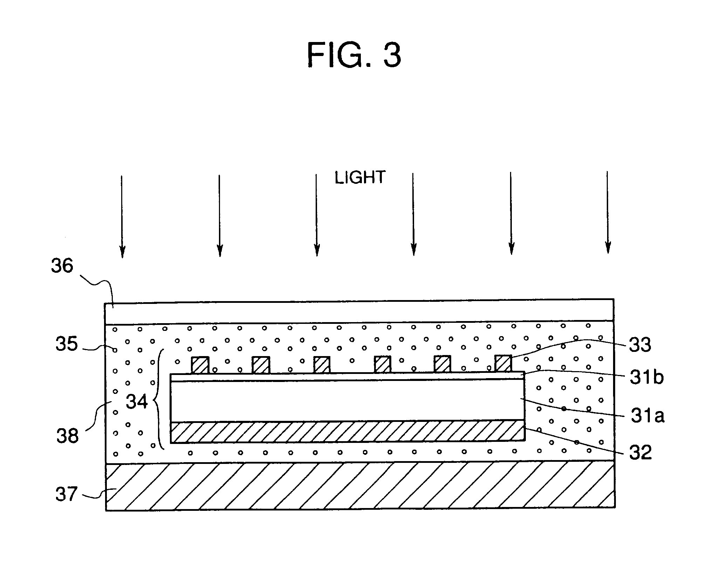

Gas phase POCl₃ was diffused on a p-type silicon single crystal wafer having a thickness of 0.2 mm so that a pn junction (a p-layer 31a, and an n-layer 31b) was formed. Then, aluminum was evaporated on the entire surface of the p-layer 31a so that a backside electrode 32 was formed. Silver paste having a width of 200 µm was sintered on the n-layer 31b at pitches of 5 mm so that an electric-current ejection pole 33 was formed. As a result, a photovoltaic element 34 schematically shown in Fig. 3 was formed.

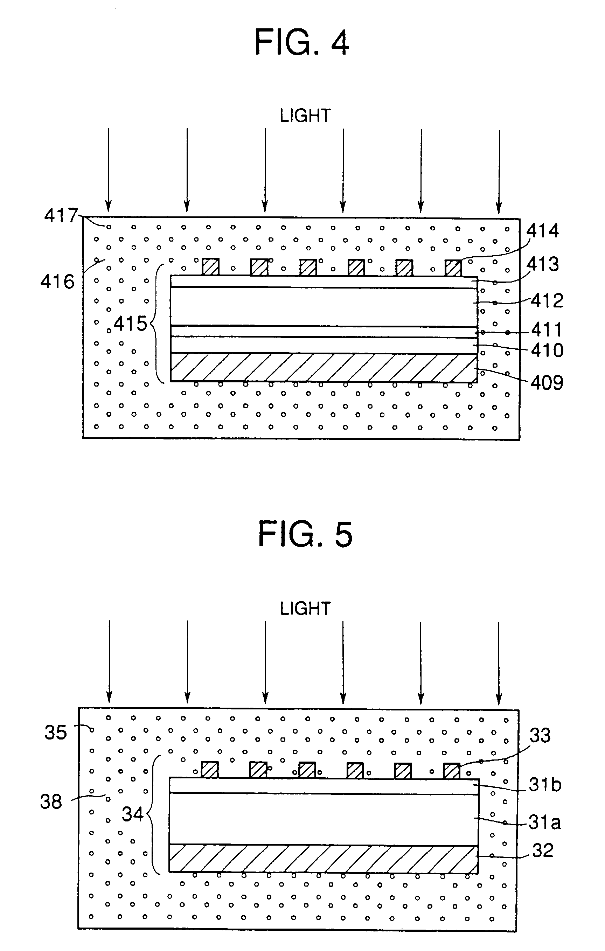

The above photovoltaic element 34 was dipped in the foregoing dispersed solution, ejected from the same, and heated at 100°C for 20 minutes to be dried. The high voltage mercury lamp beams of 365 nm were applied at 50 mW/cm² for 30 seconds. As a result, a solar cell schematically shown in Fig. 5 was obtained, the solar cell having a sealing film, the thickness of which was 80 µm and which was formed on the entire surface of the photoelectric conversion surface and the entire surface of the backside.

### Comparative Example 10

Sealing was performed similarly to Example 10 except for that no glass beads serving as the light transmissive particles was used but only the resin was used.

The conversion efficiency and the surface hardness of the solar cells according to Example 10 and Comparative Example 10 were evaluated. As a result, the sample according to Example 10 exhibited superior results as shown in Table 10 to Comparative Example 10.

### Example 11

50 parts by weight of acrylate epoxy oligomer, the number average molecular weight of which was 600 and which was hardening resin, 50 parts by weight of styrene butadiene resin (monomer composition: styrene/butadiene = 80/20), the number average molecular weight of which was 8000 and which was thermoplastic resin and 30 parts by weight of spherical titanium oxide particles, the oil absorption quantity of which was 30 g/100 g, the average particle size of which was 0.017 µm and which were light transmissive particles were uniformly dissolved and dispersed in 60 parts by weight of ethyl acetate ester. As a result, a dispersed solution of the resin composition was obtained.

Chrome was, by a DC sputtering method, deposited on a SUS 430 stainless steel substrate 409 having a thickness of 1 mm so that a chrome layer 410 having a thickness of 2000Å was formed. Then, a RF plasma CVD method was employed to form an n-type semiconductor layer 411 having 500Å was formed under conditions that the proportion of SiH₄ gas/PH₃ gas was 99.98/0.02, the pressure was 1 Torr and RF power was 100 W.

Then, an i-type semiconductor layer 412 having a thickness of 5000Å was formed under conditions that the proportion of SiH₄ gas/H₂ gas was 30/70, the pressure was 1.5 Torr and RF power was 50 W.

Then, a p-type semiconductor layer 413 having a thickness of 200Å was formed under conditions that the proportion of SiH₄ gas/H₂ gas/BF₃ gas was 3/96.7/0.3, the pressure was 1.2 Torr and RF power was 1 KW. As a result, a semiconductor layer having a pin junction was formed.

Then, In was evaporated on the surface under condition that the O₂ gas pressure was 0.5 Torr, so that a transparent conductive film 16 having a thickness of 700Å and made of indium oxide was formed. Silver paste having a width of 200 µm was used at intervals of 5 mm, so that an electric current ejecting pole 414 was formed. Thus, a photovoltaic element 415 schematically shown in Fig. 4 was formed.

The above photovoltaic element 415 was dipped in the foregoing

dispersed solution, ejected from the same, and heated at 100°C for 20 minutes to be dried. The high voltage mercury lamp beams of 365 nm were applied at 50 mW/cm² for 30 seconds. As a result, a solar cell schematically shown in Fig. 4 was obtained, the solar cell having a sealing film, the thickness of which was 50 µm and which was formed on the entire surface of the photoelectric conversion surface and the entire surface of the backside.

### Comparative Example 11

Sealing was performed similarly to Example 11 except for that no titanium oxide particles serving as the light transmissive particles were used but only the resin was used.

The conversion efficiency and the surface hardness of the solar cells according to Example 11 and Comparative Example 11 were evaluated. As a result, the sample according to Example 11 exhibited superior results as shown in Table 10 to Comparative Example 11.

### Example 12

60 parts by weight of acrylate urethane oligomer, the number average molecular weight of which was 200 and which was hardening resin and 40 parts by weight of styrene resin, the number average molecular weight of which was 20000 and which was the thermoplastic resin and 65 parts by weight of monolithic urethane rubber particles, the oil absorption quantity of which was 50 g/100 g, the average particle size of which was 50 µm and which were light transmissive particles were uniformly dissolved and dispersed in 50 parts by weight of toluene. As a result, a dispersed solution of the resin composition was obtained.

The same photovoltaic element 415 as that according to Example 8 was dipped in the foregoing dispersed solution, ejected from the same, and heated at 100°C for 20 minutes to be dried. The high voltage mercury lamp beams of 365 nm were applied at 50 mW/cm² for 30 seconds. As a result, a solar cell schematically shown in Fig. 4 was obtained, the solar cell having a sealing film, the thickness of which was 70 µm and which was formed on the entire surface of the photoelectric conversion surface and the entire surface of the backside.

### Comparative Example 12

Sealing was performed similarly to Example 12 except for that no monolithic urethane rubber particles serving as the light transmissive particles were used but only the resin was used.

The conversion efficiency and the surface hardness of the solar cells according to Example 12 and Comparative Example 12 were evaluated. As a result, the sample according to Example 12 exhibited superior results as shown in Table 10 to Comparative Example 12.

The reason for this is that the uniformity of the sealing film to be significantly improved. As a result, the film thickness reduction in the peripheral portion of the photovoltaic element and in a portion on the electric current ejection pole could be prevented. Therefore, the deterioration in the conversion efficiency was prevented significantly.

### Example 13

70 parts by weight of acrylate ester oligomer, the number average molecular weight of which was 400 and which was hardening resin, 30 parts by weight of acrylic resin, the monomer composition of which was methyl methacrylate/butyl methacrylate/acrylic acid = 30/60/10, the number average molecular weight of which was 10000 and which was thermoplastic resin and 100 parts by weight of spherical glass bead, the oil absorption quantity of which was 20 g/100 g, the average particle size of which was 60 µm and which were light transmissive particles were uniformly dissolved and dispersed in 40 parts by weight of methylethyl ketone. As a result, a dispersed solution of the resin composition was obtained.

The same photovoltaic element 34 as that according to Example 10 was dipped in the foregoing dispersed solution, ejected from the same, and heated at 100°C for 20 minutes to be dried. The high voltage mercury lamp beams of 365 nm were applied at 50 mW/cm² for 30 seconds. As a result, a solar cell schematically shown in Fig. 5 was obtained, the solar cell having a sealing film, the thickness of which was 80 µm and which was formed on the entire surface of the photoelectric conversion surface and the entire surface of the backside.

### Comparative Example 13

Sealing was performed similarly to Example 13 except for that no glass beads serving as the light transmissive particles were used but only the resin was used.

The conversion efficiency and the surface hardness of the solar cells according to Example 13 and Comparative Example 13 were evaluated. As a result, the sample according to Example 13 exhibited superior results as shown in Table 10 to Comparative Example 13.

### Example 14

50 parts by weight of acrylate ester oligomer, the number average molecular weight of which was 600 and which was hardening resin, 50 parts by weight of acrylic resin, the monomer composition of which was methyl acrylate/butyl methacrylate/methacrylic acid = 50/35/15, the number average molecular weight of which was 15000 and which was the thermoplastic resin and 30 parts by weight of spherical titanium oxide, the oil absorption quantity of which was 30 g/100 g, the average particle size of which was 0.017 µm and which were light transmissive particles were uniformly dissolved and dispersed in 60 parts by weight of ethyl acetate ester. As a result, a dispersed solution of the resin composition was obtained.

The same photovoltaic element 415 as that according to Example 11 was dipped in the foregoing dispersed solution, ejected from the same, and heated at 100°C for 20 minutes to be dried. The high voltage mercury lamp beams of 365 nm were applied at 50 mW/cm² for 30 seconds. As a result, a solar cell schematically shown in Fig. 4 was obtained, the solar cell having a sealing film, the thickness of which was 50 µm and which was formed on the entire surface of the photoelectric conversion surface and the entire surface of the backside.

### Comparative Example 14

Sealing was performed similarly to Example 14 except for that no titanium oxide particles serving as the light transmissive particles were used but only the resin was used.

The conversion efficiency and the surface hardness of the solar cells according to Example 14 and Comparative Example 14 were evaluated. As a result, the sample according to Example 14 exhibited superior results as shown in Table 10 to Comparative Example 14.

### Example 15

60 parts by weight of acrylate urethane oligomer, the number average molecular weight of which was 200 and which was hardening resin, 40 parts by weight of acrylic resin, the monomer composition of which was butyl methacrylate/methacrylic acid = 80/20, the number average molecular weight of which was 20000 and which was the thermoplastic resin and 65 parts by weight of monolithic urethane rubber particles, the oil absorption quantity of which was 50 g/100 g, the average particle size of which was 50 µm and which were light transmissive particles were uniformly dissolved and dispersed in 50 parts by weight of toluene. As a result, a dispersed solution of the resin composition was obtained.

The same photovoltaic element 415 as that according to Example 11 was dipped in the foregoing dispersed solution, ejected from the same, and heated at 100°C for 20 minutes to be dried. The high voltage mercury lamp beams of 365 nm were applied at 50 mW/ cm² for 30 seconds. As a result, a solar cell schematically shown in Fig. 4 was obtained, the solar cell having a sealing film, the thickness of which was 70 µm and which was formed on the entire surface of the photoelectric conversion surface and the entire surface of the backside.

### Comparative Example 15

Sealing was performed similarly to Example 15 except for that no monolithic urethane rubber particles serving as the light transmissive particles were used but only the resin was used.

The conversion efficiency and the surface hardness of the solar cells according to Example 15 and Comparative Example 15 were evaluated. The results are shown in Table 10. The sample according to Example 15 exhibited superior results as shown in Table 10 to Comparative Example 15 because of the same reason as that described in Example 12.

### Example 16

70 parts by weight of acrylate ester oligomer, the number average molecular weight of which was 400 and which was hardening resin, 30 parts by weight of acrylic resin, the monomer composition of which was styrene/methyl methacrylate/butyl methacrylate/ acrylic acid = 20/30/40/10, the number average molecular weight of which was 10000 and which was the thermoplastic resin and 100 parts by weight of spherical glass beads, the oil absorption quantity of which was 20 g/100 g, the average particle size of which was 60 µm and which were light transmissive particles were uniformly dissolved and dispersed in 50 parts by weight of methylethyl ketone. As a result, a dispersed solution of the resin composition was obtained.

The same photovoltaic element 34 as that according to Example 10 was dipped in the foregoing dispersed solution, ejected from the same, and heated at 100°C for 20 minutes to be dried. The high voltage mercury lamp beams of 365 nm were applied at 50 mW/cm² for 30 seconds. As a result, a solar cell schematically shown in Fig. 5 was obtained, the solar cell having a sealing film, the thickness of which was 80 µm and which was formed on the entire surface of the photoelectric conversion surface and the entire surface of the backside.

### Comparative Example 16

Sealing was performed similarly to Example 16 except for that no glass beads serving as the light transmissive particles were used but only the resin was used.

The conversion efficiency and the surface hardness of the solar cells according to Example 16 and Comparative Example 16 were evaluated. As a result, the sample according to Example 16 exhibited superior results as shown in Table 10 to Comparative Example 16 because of the same reason as that described in Example 10.

### Example 17

50 parts by weight of acrylate epoxy oligomer, the number average molecular weight of which was 600 and which was hardening resin, 50 parts by weight of acrylic resin, the monomer composition of which was styrene/methyl acrylate/butyl methacrylate/methacrylic acid = 20/30/35/15, the number average molecular weight of which was 15000 and which was the thermoplastic resin and 30 parts by weight of spherical titanium oxide, the oil absorption quantity of which was 30 g/100 g, the average particle size of which was 0.017 µm and which were light transmissive particles were uniformly dissolved and dispersed in 60 parts by weight of ethyl acetate ester. As a result, a dispersed solution of the resin composition was obtained.

The same photovoltaic element 415 was that according to Example 11 was dipped in the foregoing dispersed solution, ejected from the same, and heated at 100°C for 20 minutes to be dried. The high voltage mercury lamp beams of 365 nm were applied at 50 mW/cm² for 30 seconds. As a result, a solar cell schematically shown in Fig. 4 was obtained, the solar cell having a sealing film, the thickness of which was 50 µm and which was formed on the entire surface of the photoelectric conversion surface and the entire surface of the backside.

### Comparative Example 17

Sealing was performed similarly to Example 17 except for that no titanium oxide serving as the light transmissive particles were used but only the resin was used.

The conversion efficiency and the surface hardness of the solar cells according to Example 17 and Comparative Example 17 were evaluated. As a result, the sample according to Example 17 exhibited superior results as shown in Table 10 to Comparative Example 17 because of the same reason as that described in Example 10.

### Example 18

60 parts by weight of acrylate urethane oligomer, the number average molecular weight of which was 200 and which was hardening resin, 40 parts by weight of styrene acrylic resin, the monomer composition of which was styrene/ethyl acrylate/butyl methacrylate/ methacrylic acid = 30/30/20/20, the number average molecular weight of which was 20000 and which was the thermoplastic resin and 65 parts by weight of monolithic urethane particles, the oil absorption quantity of which was 50 g/100 g, the average particle size of which was 50 µm and which were light transmissive particles were uniformly dissolved and dispersed in 50 parts by weight of toluene. As a result, a dispersed solution of the resin composition was obtained.

The same photovoltaic element 415 as that according to Example 11 was dipped in the foregoing dispersed solution, ejected from the same, and heated at 100°C for 20 minutes to be dried. The high voltage mercury lamp beams of 365 nm were applied at 50 mW/cm² for 30 seconds. As a result, a solar cell schematically shown in Fig. 4 was obtained, the solar cell having a sealing film, the thickness of which was 70 µm and which was formed on the entire surface of the photoelectric conversion surface and the entire surface of the backside.

### Comparative Example 18

Sealing was performed similarly to Example 18 except for that no monolithic urethane rubber particles serving as the light transmissive particles were used but only the resin was used.

The conversion efficiency and the surface hardness of the solar cells according to Example 18 and Comparative Example 18 were evaluated. As a result, the sample according to Example 18 exhibited superior results as shown in Table 10 to Comparative Example 18 because of the same reason as that described in Example 12.

**Table 10-1**

| | Initial Conversion Efficiency | Weathering Resistance | Surface Hardness | Damage Resistance | High Temperature and High Humidity Resistance | Flexibility |
|---|---|---|---|---|---|---|
| Example 10 | 13% | 12.5% | 7 H | o | 13% | - |
| | | | | | | |
| Comparative Example 10 | 13% | 12.0% | 4 H | Δ | 3% | |
| Example 11 | 8% | 7.5% | 5 H | o | 8% | - |
| | | | | | | |
| Comparative Example 11 | 8% | 7.0% | 3 H | Δ | 3% | |
| Example 12 | 8% | 7.5% | 6 H | o | 8% | o |
| | | | | | | |
| Comparative Example 12 | 8% | 7.0% | 5 H | Δ | 3% | × |
| Example 13 | 13% | 12.6% | 7 H | o | 13% | - |
| | | | | | | |
| Comparative Example 13 | 13% | 12.3% | 5 H | Δ | 3% | |
| Example 14 | 8% | 7.5% | 6 H | o | 8% | - |
| | | | | | | |
| Comparative Example 14 | 8% | 7.0% | 4 H | Δ | 3% | |
| Example 15 | 8% | 7.5% | 6 H | o | 8% | o |
| | | | | | | |
| Comparative Example 15 | 8% | 7.0% | 5 H | Δ | 3% | × |
| Example 16 | 13.3% | 12.9% | 7 H | o | 13.3% | - |
| | | | | | | |
| Comparative Example 16 | 13.3% | 12.6% | 6 H | Δ | 3% | |

**Table 10-2**

| | Initial Conversion Efficiency | Weathering Resistance | Surface Hardness | Damage Resistance | High Temperature and High Humidity Resistance | Flexibility |
|---|---|---|---|---|---|---|
| Example 17 | 8.4% | 7.9% | 6 H | o | 8.4% | - |
| | | | | | | |
| Comparative Example 17 | 8.4% | 7.6% | 5 H | Δ | 3% | |
| Example 18 | 8.4% | 7.9% | 6 H | o | 8.4% | o |
| | | | | | | |
| Comparative Example 18 | 8.4% | 7.6% | 6 H | Δ | 3% | × |

The sealing material according to each of Examples exhibited excellent characteristics such as the surface hardness, the total light transmissivity and the adhesivity. Further, deterioration can be prevented significantly.

In addition, the samples according to Examples of the present invention exhibited excellent results in various accelerated test simulated to an actual use of the solar cell, for example, a cycle test composed of hot conditions and cold conditions, high temperature resistance test and water dipping test.

Moreover, it was found that a semiconductor device according to the present invention such as a solar cell, a photosensor or a display is able to be operated stably for a long time while exhibiting excellent characteristics.

## Claims

1. A resin sealing composition of a semiconductor device comprising:
(1) at least one hardening resin having an acrylic group, or an acrylic group with a substituent at the position α or position β and having hardening characteristics; and
(2) at least one thermoplastic resin having an average molecular weight of 5000 to 50000, greater than the average molecular weight of said hardening resin,
dissolved in an organic solvent.

2. A resin sealing diposition according to claim 1, wherein the average molecular of said hardening resin is 3000 or less.

3. A resin sealing composition according to claim 1, wherein said thermoplastic resin is a styrene polymer, an acrylic polymer, or a styrene acrylic polymer.

4. A resin sealing composition according to any one of claims 1 to 3, further comprising light transmissive particles dispersively.

5. A semiconductor device coated with a resin sealing composition according to claim 1 on a photoelectric conversion surface or non-photoelectric conversion surface thereof.

6. A semiconductor device according to claim 5, wherein the number average molecular of said hardening resin is 3000 or less.

7. A semiconductor device according to claim 5, wherein said thermoplastic resin is a styrene polymer, an acrylic polymer, or a styrene acrylic polymer.

8. A semiconductor device according to any one of claims 5 to 7, further comprising light transmissive particles dispersively.

9. A semiconductor device according to claim 5, wherein said semiconductor apparatus is a solar cell.

10. A semiconductor device according to claim 9, wherein a collecting electrode is wired in said solar cell.

## Patentansprüche

1. Dichtharzzusammensetzung einer Halbleitervorrichtung enthaltend:
(1) zumindest ein Härtungsharz, das eine Acrylgruppe aufweist oder eine Acrylgruppe mit einem Substituent in einer α Stellung oder einer β Stellung und Härtungseigenschaften aufweist; und
(2) zumindest ein thermoplastisches Harz, das ein durchschnittliches Molekulargewicht von 5000 bis 50 000 größer als das durchschnittliche Molekulargewicht von dem Härtungsharz hat, gelöst in einem organischen Lösungsmittel.

2. Dichtharzzusammensetzung nach Anspruch 1, worin das durchschnittliche Molekulargewicht von dem Härtungsharz 3000 oder weniger beträgt.

3. Dichtharzzusammensetzung nach Anspruch 1, worin das thermoplastische Harz ein Styrolpolymer, ein Acrylpolymer oder ein Styrolacrylpolymer ist.

4. Dichtharzzusammensetzung nach einem der Ansprüche 1 bis 3, die weiter lichtdurchlässig Teilchen dispergiert enthält.

5. Halbleitervorrichtung, die mit einer Dichtharzzusammensetzung nach Anspruch 1 beschichtet ist, einer photoelektrischen Umwandlungs-Oberfläche oder nichtphotoelektrischen Umwandlungs-Oberfläche darauf.

6. Dichtharzvorrichtung nach Anspruch 5, worin das durchschnittliche Molekulargewicht der Zahl nach von diesem Härtungsharz 3000 oder weniger beträgt.

7. Halbleitervorrichtung nach Anspruch 5, worin das thermoplastische Harz ein Styrolpolymer, ein Acrylpolymer oder ein Styrolacrylpolymer ist.

8. Halbleitervorrichtung nach einem der Ansprüche 5 bis 7, das weiter lichtdurchlässig Teilchen dispergiert enthält.

9. Halbleitervorrichtung nach Anspruch 5, worin die Halbleitervorrichtung eine Solarzelle ist.

10. Halbleitervorrichtung nach Anspruch 9, worin eine Sammelelektrode in der Solarzelle verdrahtet ist.

## Revendications

1. Composition de résines pour le scellement d'un dispositif semiconducteur comportant :
(1) au moins une résine durcissable ayant un groupe acrylique, ou un groupe acrylique avec un substituant en position alpha ou en position bêta et ayant des caractéristiques de durcissement ; et
(2) au moins une résine thermoplastique ayant un poids moléculaire moyen de 5000 à 50 000, supérieur au poids moléculaire moyen de ladite résine durcissable, en dissolution dans un solvant organique.

2. Composition de résines pour le scellement selon la revendication 1, dans laquelle le poids moléculaire moyen de ladite résine durcissable est de 3000 ou moins.

3. Composition de résines pour le scellement selon la revendication 1, dans laquelle ladite résine thermoplastique est un polymère de styrène, un polymère acrylique ou un polymère acrylique de styrène.

4. Composition de résines pour le scellement selon l'une quelconque des revendications 1 à 3, comportant en outre, en dispersion, des particules transmettant la lumière.

5. Dispositif semiconducteur revêtu d'une composition de résines pour le scellement selon la revendication 1 sur une surface de conversion photoélectrique ou une surface de non-conversion photoélectrique de ce dispositif.

6. Dispositif semiconducteur selon la revendication 5, dans lequel le poids moléculaire moyen en nombre de ladite résine durcissable est de 3000 ou moins.

7. Dispositif semiconducteur selon la revendication 5, dans lequel ladite résine thermoplastique est un polymère de styrène, un polymère acrylique ou un polymère acrylique de styrène.

8. Dispositif semiconducteur selon l'une quelconque des revendications 5 à 7, comportant en outre, en dispersion, des particules transmettant la lumière.

9. Dispositif semiconducteur selon la revendication 5, dans lequel ledit dispositif semiconducteur est une cellule solaire.

10. Dispositif semiconducteur selon la revendication 9, dans lequel une électrode collectrice est câblée dans ladite cellule solaire.
